# EUROPEAN PATENT APPLICATION

(11) **EP 4 718 966 A1**
(43) Date of publication of application: **01.04.2026**
(21) Application number: 25192123.5
(22) Date of filing: 28.07.2025
(51) Int. Cl.: H10B 10/00, G11C 11/412, H10D 84/01, H10D 30/00, H10D 84/85, H10D 88/00, H10D 89/10

(54) **COMPLEMENTARY FIELD-EFFECT TRANSISTOR STATIC RANDOM-ACCESS MEMORY**

(30) Priority: 27.09.2024 US 202418900291
(71) Applicant: INTEL Corporation, Santa Clara, CA 95054 (US)
(72) Inventor: AUGUSTINE, Charles, Portland, OR 97229 (US); MERCHANT, Feroze, Austin, TX 78750 (US); GHOSH, Amlan, Mebane, NC 27302 (US)
(74) Representative: Viering, Jentschura & Partner mbB Patent- und Rechtsanwälte

(57) **Abstract**

Embodiments herein relate to a Static Random-Access Memory (SRAM) cell having a four-level complementary-field effect transistor (CFET) structure. In an example implementation, a first, bottom level includes one or more n-channel metal-oxide-semiconductor field-effect transistors (nMOSs), a second level includes one or more pMOS transistors, a third level includes one or more pMOS transistors and a fourth, top level includes one or more nMOS transistors. The transistors can be connected using conductive paths which extend in bottom metal layers, top metal layers and intermediate metal layers between the two pMOS levels. In an example implementation, a six-transistor memory cell is provided.

## Description

### BACKGROUND

The demand for memory in computing devices has increased, e.g., as larger on-die caches are employed such as in high-performance processors. Static Random-Access Memory (SRAM) is a candidate for supporting these workloads and providing on-chip high density memory. However, various challenges are encountered in meeting performance and scalability goals.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts plots of normalized density versus technology node for logic density (plot 100) and Static Random-Access Memory (SRAM) cell density (plot 101), in accordance with various embodiments.
FIG. 2 depicts a cross-sectional view of an example two-level CFET device 200, including an n-channel metal-oxide-semiconductor field-effect transistors (MOSFET or nMOS) layer 230 above a p-channel MOSFET (pMOS) layer 220, according to various embodiments.
FIG. 3 depicts a cross-sectional view of an example four-level CFET device 300, including pMOS layers 330 and 340 between nMOS layers 320 and 350, according to various embodiments.
FIG. 4A depicts a circuit diagram of an example six-transistor (6T) Static Random-Access Memory (SRAM) cell 400, according to various embodiments.
FIG. 4B depicts an example arrangement of the transistors of the SRAM cell of FIG. 4A in the nMOS layers 320 and 350 and the pMOS layers 330 and 340 of FIG. 3, according to various embodiments.
FIG. 5 depicts a layout of the nMOS layer 230 of FIG. 2, in an example two-level implementation of the SRAM cell of FIG. 4A, according to various embodiments.
FIG. 6 depicts a layout of the pMOS layer 220 of FIG. 2, in the example two-level implementation of the SRAM cell of FIG. 4A, according to various embodiments.
FIG. 7 depicts a layout of front and bottom metal layers, M0 and BM0, respectively, in an example implementation of the SRAM cell of FIG. 4A, consistent with FIGs. 5 and 6, according to various embodiments.
FIG. 8 depicts a layout of the top nMOS layer 350 of FIG. 3, in an example four-level implementation of the SRAM cell of FIG. 4A, according to various embodiments.
FIG. 9 depicts a layout of the top-middle pMOS layer 340 of FIG. 3, in an example four-level implementation of the SRAM cell of FIG. 4A, according to various embodiments.
FIG. 10 depicts a layout of the bottom-middle pMOS layer 330 of FIG. 3, in an example four-level implementation of the SRAM cell of FIG. 4A, according to various embodiments.
FIG. 11 depicts a layout of the bottom nMOS layer 320 of FIG. 3, in an example four-level implementation of the SRAM cell of FIG. 4A, according to various embodiments.
FIG. 12 depicts a layout of front, intermediate and bottom metal layers in an example implementation of the SRAM cell of FIG. 4A, consistent with FIGs. 8-11, according to various embodiments.
FIG. 13A depicts a layout of control gate and sources/drains of conductive paths of the top nMOS layer 350 of FIG. 3, in an example four-level implementation of the SRAM cell of FIG. 4A, according to various embodiments.
FIG. 13B depicts a layout of control gate and source/drain paths of the top-middle pMOS layer 340 of FIG. 3, in an example four-level implementation of the SRAM cell of FIG. 4A, according to various embodiments.
FIG. 13C depicts a layout of control gate and source/drain paths of the bottom-middle pMOS layer 330 of FIG. 3, in an example four-level implementation of the SRAM cell of FIG. 4A, according to various embodiments.
FIG. 13D depicts a layout of control gate and source/drain paths of the bottom nMOS layer 320 of FIG. 3, in an example four-level implementation of the SRAM cell of FIG. 4A, according to various embodiments.
FIG. 14 depicts an example perspective view of different conductive paths in an example four-level implementation of the SRAM cell of FIG. 4A, according to various embodiments.
FIG. 15 illustrates an example of components that may be present in a computing system 1550 for implementing the techniques (e.g., operations, processes, methods, and methodologies) described herein.

### DETAILED DESCRIPTION

As mentioned at the outset, various challenges are encountered in meeting performance and scalability goals for memory such as SRAM.

On-chip cache memories are an integral part of computing systems. Both memory capacity and memory bandwidth need to be scaled to meet the demands of existing and emerging workloads. One approach to meeting these demands is complementary-field effect transistor (CFET) technology. CFET technology can potentially offer solutions to memory scaling problems due to vertical stacking of a p-type metal-oxide-semiconductor field-effect transistor (pMOSFET or pMOS) and an n-type MOSFET or nMOS. However, further improvements are desirable.

The solutions provided herein address the above and other issues. In one aspect, a CFET device is provided which includes more than two layers of transistors. For example, a four-layer stack can be provided with two pMOS layers between top and bottom nMOS layers. Additional intermediate metal layers can be provided between the two pMOS layers to provide interconnections between the layers.

SRAM scaling with a four layer CFET is 50% compared to a two-layer device. While additional layers could potentially be used, e.g., more than four, this can be challenging due to the exposing of internal nodes at the boundary of a cell which can potentially result in a short circuit to an adjacent cell.

In an example implementation, the four-level device comprises a six-transistor (6T) SRAM cell with six transistors distributed across the four layers and interconnects between the layers. The SRAM cell can be controlled by a primary bit line (BL) and a complementary bit line (BLB) which are routed in different layers since the access transistors of the SRAM cell are distributed in different layers. For example, BLB can be routed in a top (front side) metal layer M0 and BL can be routed in a bottom (back side) metal layer BM0.

These and other features will be further apparent in view of the following discussion.

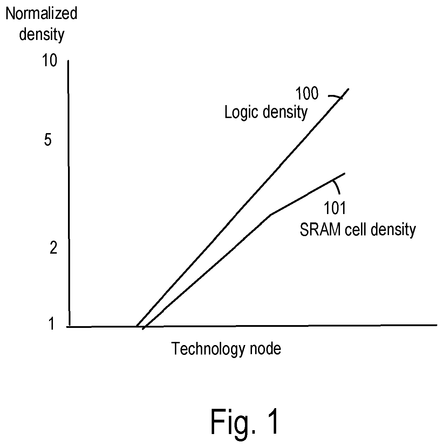

FIG. 1 depicts plots of normalized density versus technology node for logic density (plot 100) and Static Random-Access Memory (SRAM) cell density (plot 101), in accordance with various embodiments. Logic density continues to increase in proportion to the technology node, which represents an increasingly smaller dimension along the horizontal axis. However, SRAM cell density has increased at a lower rate, resulting in a disparity between logic and SRAM scaling across technology generations. The solutions provided herein address this issue by improving SRAM cell density.

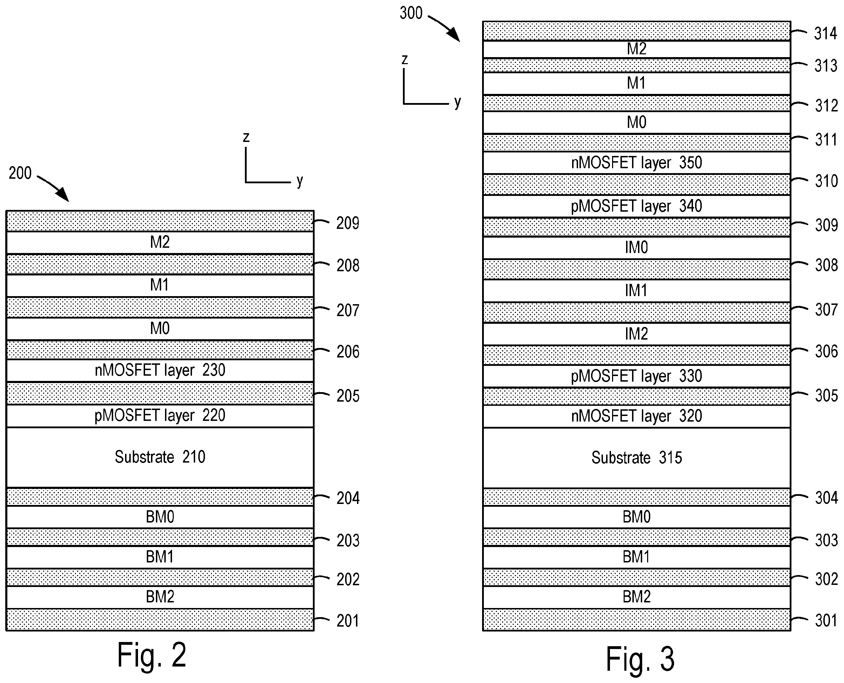

FIG. 2 depicts a cross-sectional view of an example two-level CFET device 200, including an n-channel MOSFET (nMOS) layer 230 above a p-channel MOSFET (pMOS) layer 220, according to various embodiments. The device has a stacked structure which includes a substrate 210, a pMOSFET layer 220 formed on the substrate and the nMOSFET layer 230 formed on the pMOSFET layer. The pMOSFET layer (a p-channel active layer) can include an n-type substrate with p-doped regions, and the nMOSFET layer (an n-channel active layer) can include a p-type substrate with n-doped regions. Additionally, example bottom metal layer BM0-BM2 and top metal layers M0-M2 can be provided below and above the substrate, respectively. Dielectric layers 201-209 provide insulation between the metal layers and active layers and at the top and bottom of the stack.

FIG. 3 depicts a cross-sectional view of an example four-level CFET device 300, including pMOS layers 330 and 340 between nMOS layers 320 and 350, according to various embodiments. The four-level device includes a substrate 315 and separates the nMOSFET layer 230 into top and bottom nMOS layers 350 and 320, respectively, also referred to as n-type transistor layers. The device 300 comprises a stack of layers. The pMOSFET layer 220 is separated into top-middle and bottom-middle pMOS layers 340 and 330, also referred to as p-type transistor layers. The device further includes intermediate metal layers IM0 and IM1 to facilitate electrical connections for one or both of the pMOS layers. Additionally, example bottom metal layers BM0-BM2 and top metal layers M0-M2 can be provided below and above the substrate, respectively. Dielectric layers 301-314 provide insulation between the metal layers and active layers and at the top and bottom of the stack.

The layers 320, 330, 340 and 350 can be considered to be first, second, third and fourth layers, respectively, in ascending order in the CFET device. The layers 320 and 350 can be considered to be first and second nMOS layers (n-type transistor layers), respectively. The layers 330 and 340 can be considered to be first and second pMOS layers (p-type transistor layers), respectively. The four layers may be considered to be stacked one above the other, e.g., one above the other in a sequence, such that first n-type transistor layer is above the substrate, the first p-type transistor layer is above the first n-type transistor layer, the second p-type transistor layer is above the first p-type transistor layer, and the second n-type transistor layer is above the second p-type transistor layer.

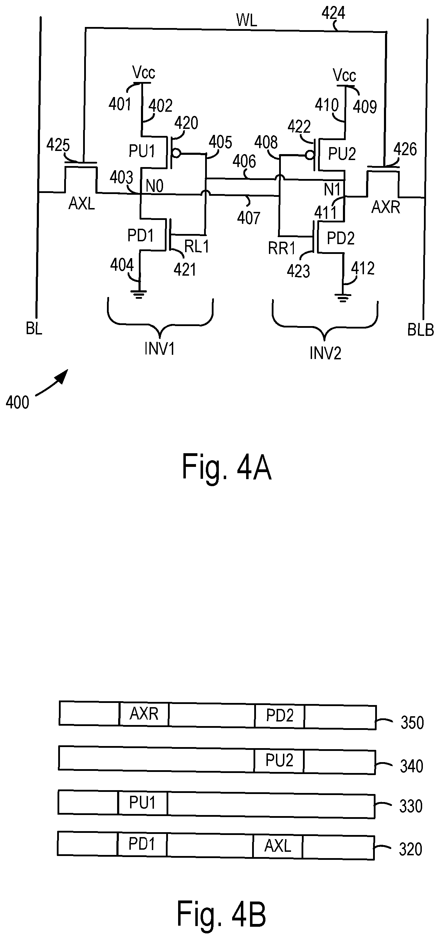

FIG. 4A depicts a circuit diagram of an example six-transistor (6T) Static Random-Access Memory (SRAM) cell 400, according to various embodiments. The cell includes left and right bit line access transistors, AXL and AXR, respectively, coupled to a bit line BL and a complementary bit line BLB, respectively, and to back-to-back inverters INV1 and INV2, respectively. AXL is an access transistor of INV1 (a first access transistor), and AXR is an access transistor of INV2 (a second access transistor). INV1 includes a pMOS transistor PU1 and an nMOS transistor PD1 in series. A source 402 of PU1 is coupled to a power supply node 401 at Vcc, a drain of PU1 at node 403 is coupled to a drain of PD1 at node 403 (N0) and a source 404 of PD1 is coupled to ground. PU1 and PD1 have their control gates 420 and 421, respectively, coupled to one another by a path 405 (RL1), which is also coupled to a node 411 (N1) by a path 406.

INV2 includes a pMOS transistor PU2 and an nMOS transistor PD2 in series. A source 410 of PU2 is coupled to a power supply node 409 at Vcc, a drain of PU2 at a node 411 is coupled to a drain of PD2 at node 411 and a source 412 of PD2 is coupled to ground. PU2 and PD2 have their control gates 422 and 423, respectively, coupled to one another by a path 408 (RR1), which is also coupled to the node 403 (N0) by a path 407.

A conductive path 424 is a word line (WL) which connects the control gate 425 of AXL to the control gate 426 of AXR.

While a 6T implementation is discussed, other implementations are possible such as an 8T SRAM cell.

In the SRAM bit-cell shown in FIG. 4A, there is one control line 'WL' to control read and write operations in the bit-cell.

The nodes 403 and 411 represent outputs of INV1 and IN2, respectively. AXL is a first n-type access transistor connected to an output of the first inverter, and AXR is a second n-type access transistor connected to an output of the second inverter.

FIG. 4B depicts an example arrangement of the transistors of the SRAM cell of FIG. 4A in the nMOS layers 320 and 350 and the pMOS layers 330 and 340 of FIG. 3, according to various embodiments. PD1 and AXL are in the nMOS layer 320, PU1 is in the pMOS layer 330, PU2 is in the pMOS layer 340, and AXR and PD2 are in the nMOS layer 350. The transistors of INV1 are therefore provided in the layers 320 and 330, the bottom two layers, and the transistors of INV2 are provided in the layers 340 and 350, the top two layers. Also, the access transistor of INV1 is in the bottom layer 320, and the access transistor of INV2 is in the top layer 350.

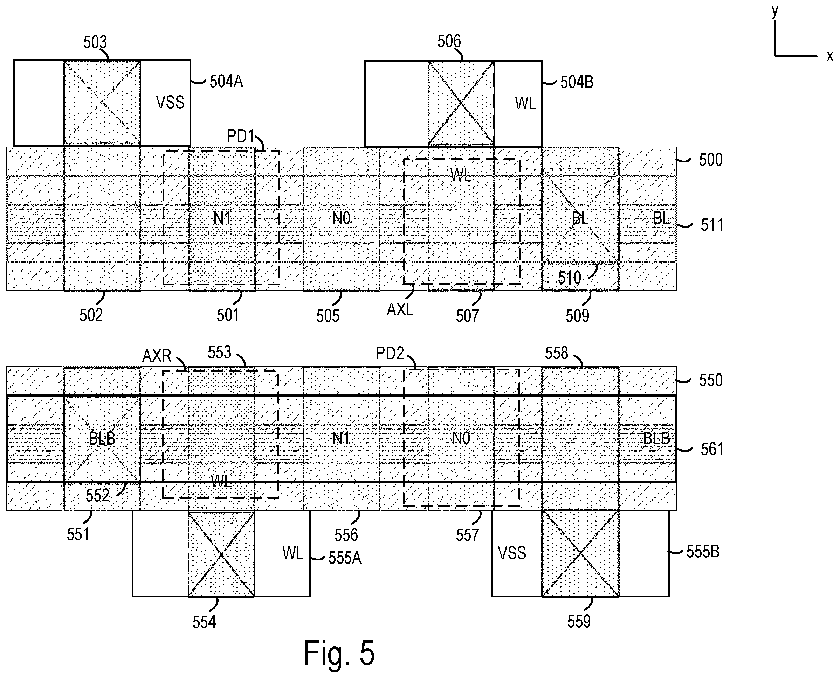

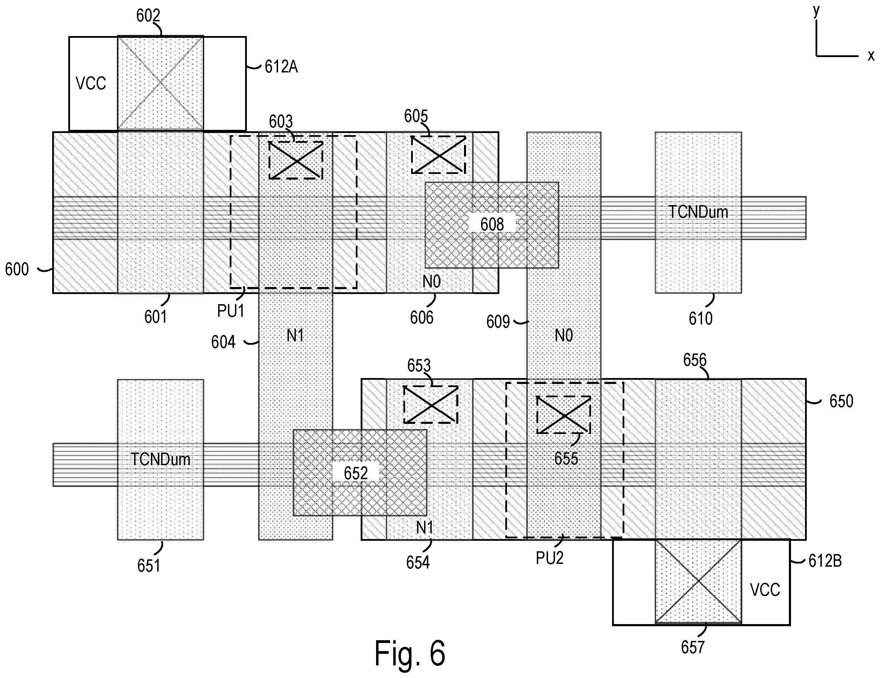

An example layout of a two-level bit-cell is depicted in FIGs. 5 and 6. In FIG. 5, the top nMOS layer contains four nMOS transistors distributed across two rows. In FIG. 6, the back side pMOS layer contains two pMOS transistors distributed across two rows. Although there are only two pMOS transistors, two rows are needed since the internal nodes of the SRAM, N0 and N1, cannot be placed at the boundary of the cell, as mentioned previously. Hence, there are empty spaces in the pMOS layer and the device utilization is 6/8 or 75%.

FIG. 5 depicts a layout of the nMOS layer 230 of FIG. 2, in an example two-level implementation of the SRAM cell of FIG. 4A, according to various embodiments. The nMOS layer includes two spaced apart n-type transistor regions 500 and 550 comprising, e.g., p-type silicon with doped n-type areas which form source/drain nodes of nMOS transistors. The layout is shown in an x-y plane which is parallel to a plane of the substrate on which the layers are formed. The region 500 includes PD1 and AXL, and the region 550 includes AXR and PD2.

Each transistor has laterally opposing source/drain terminals or regions in the n-type transistor region, and an overlying control gate. Conductive paths are formed between the transistors and top and bottom metal layers to provide the cell 400 of FIG. 4A. Some conductive paths can extend laterally in the plane of the n-type transistor regions (the x-y plane) and can comprise doped polysilicon (poly), for instance. One type of lateral conductive path can extend from an area which overlays a source/drain terminal of a transistor in the n-type transistor region to an area which is external to the n-type transistor region, to provide an area for a via to be located. The vias can extend upwards to a top metal layer, or downwards to the p-type transistor layer of FIG. 6, for example. The vias can be metal plated through-vias, for example, or other conductive material. Another type of lateral conductive path extends within the p-type layer without contacting a via, to couple the p-type transistor regions 600 and 650 (FIG. 6).

In the nMOS region 500 of FIG. 5, a conductive path 501 represents the node N1 which is a control gate of PD1, and which is coupled by a via 603 to the control gate of PU1 in the underlying pMOS layer. A conductive path 502 overlies a source/drain region of PD1 and is coupled by a via 503 to a top metal layer (M0) portion 504A to receive Vss. A conductive path 505 (node N0) overlies a source/drain region of PD1 and AXL, and is coupled by a via 605 to a corresponding node in the underlying pMOS layer. A conductive path 507, which represents the control gate of AXL and a portion of the word line WL, is coupled by a via 506 to a M0 portion 504B to receive Vwl. A conductive path 509 overlies a source/drain region of AXL and is coupled by a via 510 to a bit line 511 (BL) in M0. BL extends over the nMOS region 500 in the x direction.

In the nMOS region 550, a conductive path 551 overlies a source/drain region of AXR and is coupled by a via 552 to a bit line 561 (BLB) in M0. BLB extends over the nMOS region 550 in the x direction. A conductive path 553, which represents the control gate of AXR and a portion of the word line WL, is coupled by a via 554 to a M0 portion 555A to receive Vwl. A conductive path 556 (node N1) overlies a source/drain region of AXR and PD2, and is coupled by a via 653 (FIG. 6) to a corresponding node in the underlying pMOS layer. A conductive path 557 represents the node N0 which is a control gate of PD2, and is coupled by a via 655 (FIG. 6) to the control gate of PU2 in the underlying pMOS layer. A conductive path 558 overlies a source/drain region of PD2 and is coupled by a via 559 to a M0 portion 555B to receive Vss.

FIG. 6 depicts a layout of the pMOS layer 220 of FIG. 2, in the example two-level implementation of the SRAM cell of FIG. 4A, according to various embodiments. The pMOS layer includes two spaced apart p-type transistor regions 600 and 650 comprising, e.g., n-type silicon with doped p-type areas which form source/drain nodes of pMOS transistors. The region 600 includes PU1, and the region 650 includes PU2. A conductive path 601 overlies a source/drain region of PU1 and is coupled by a via 602 to a back side metal layer (BM0) portion 612A to receive Vcc. A conductive path 604, which represents the control gate of PU1 and the node N1, is coupled by the via 603 to the nMOS layer as discussed previously. The conductive path 604 also extends laterally in the y direction to a gate connect node (GCN) 652 (a poly-to-diffusion gate contact) which is coupled in the x direction to the conductive path 654.

A conductive path 606 overlies a source/drain region of PU1 and is coupled by a via 605 to the nMOS layer, as discussed previously. The conductive path 606 is also coupled laterally in the x direction to a conductive path 609 (N0) by a GCN 608. The conductive path 609 extends in the y direction to act as the control gate of PU2. A conductive path 610 is a dummy path or trench contact node (TCN) which is not used.

The conductive path 651 is also a dummy path which is not used. The conductive path 654 overlies a source/drain region of PU2, and is coupled by the via 653 to the nMOS layer as discussed previously. The conductive path 609 provides the control gate of PU2 and is coupled by the via 655 to the nMOS layer, as discussed previously. A conductive path 656 overlies a source/drain region of PU2 and is coupled by a via 657 to a BM0 portion 612B to receive Vcc.

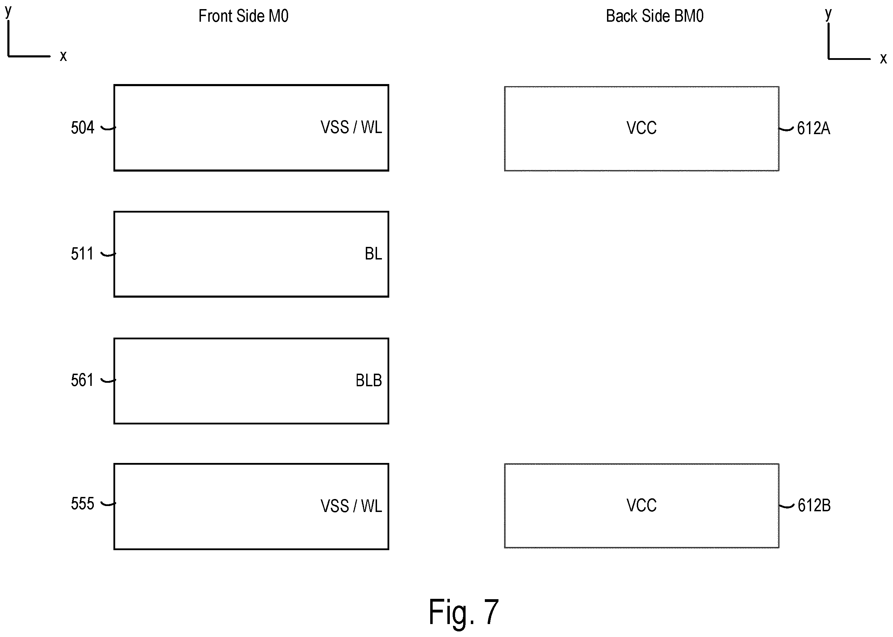

FIG. 7 depicts a layout of front and back side metal layers, M0 and BM0, respectively, in an example implementation of the SRAM cell of FIG. 4A, consistent with FIGs. 5 and 6, according to various embodiments. M0 includes portions 504, 511, 561 and 555 which can be used for Vss and WL, BL, BLB, and Vss and WL, respectively. BM0 includes portions 612A and 612B which can be used for Vcc.

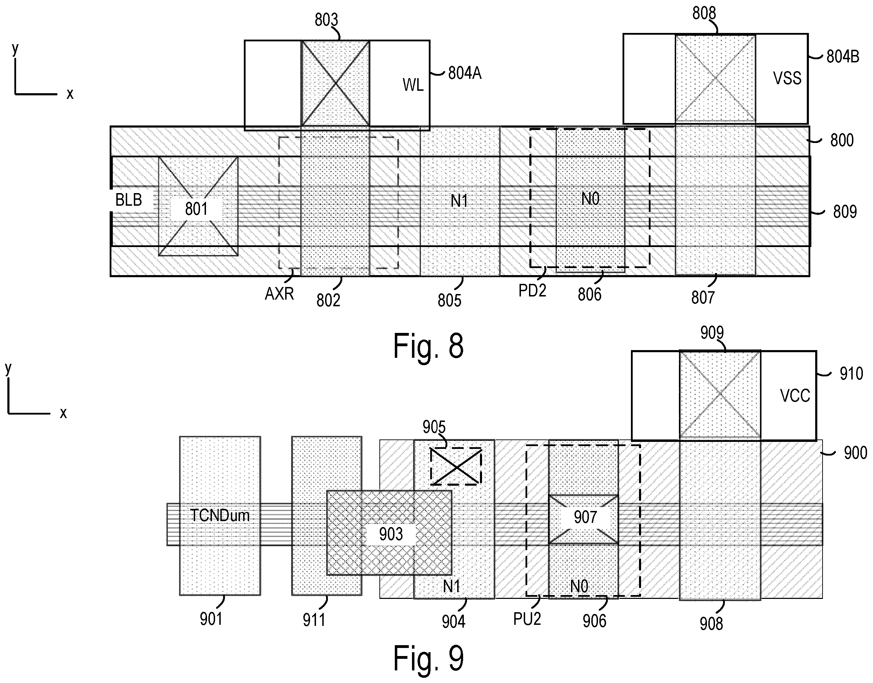

An example layout for a four-level bit-cell is depicted in FIGs. 8-11. There is one nMOS layer on the top followed by two pMOS layers and finally one nMOS layer at the bottom. The top nMOS layer (a top layer) contains transistors AXR and PD2, the top pMOS layer (a top-middle layer) contains PD2, the bottom pMOS layer (a bottom-middle layer) contains PD1, and the bottom nMOS layer (a bottom layer) contains AXL and PD1.

Cross-coupled connections between the two inverters of the cell can be achieved using a via which connects between a diffusion region and a floating gate as shown in the two pMOS layers.

The scaling achieved is 50% compared to the two-level design. Note that further scaling of the SRAM cell by further increasing the number layers may not be feasible if it exposes the internal nodes N0 and N1 at the boundary. Specifically, since other bit-cells are adjacent at both left and right sides of a given cell, internal nodes between the adjacent cells will end up being short circuited if the internal nodes are placed at the boundary of the cell.

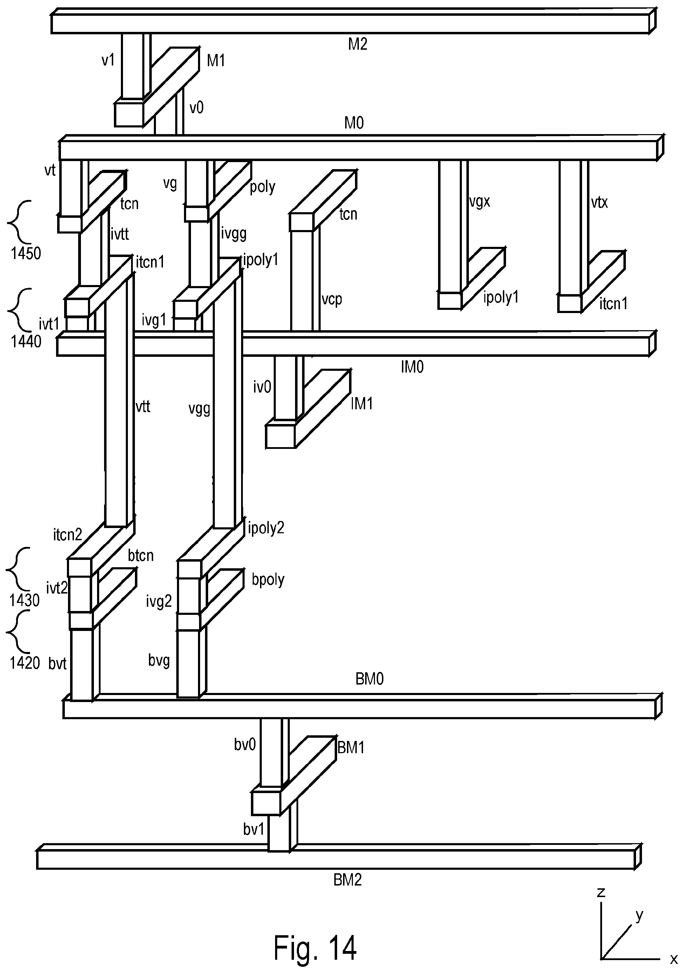

Example definitions of interconnects in the four-level CFET device are provided in FIG. 14. Interconnects can include, e.g., conductive paths in the p-type and n-type regions, in vias and in bottom, top and intermediate metal layers.

FIG. 8 depicts a layout of the top nMOS layer 350 of FIG. 3, in an example four-level implementation of the SRAM cell of FIG. 4A, according to various embodiments. The layer includes an nMOS region 800 with transistors AXR and PD2. A via 801 which is coupled to BLB (complementary bit line 809) in M0 overlies a source/drain region of AXR. A conductive path 802 forms a control gate of AXR and is coupled by a via 803 to an overlying M0 portion 804A to receive a WL voltage. A conductive path 805 (node N1) overlies a source/drain region of AXR and PD2, and is coupled by a via 905 (FIG. 9) to a corresponding node in the underlying pMOS layer. A conductive path 806 (node N0) forms a control gate of PD2 and is coupled by a via 907 to a corresponding node in the underlying pMOS layer (FIG. 9).

A conductive path 807 overlies a source/drain region of PD2 and is coupled by a via 808 to a M0 portion 804B to receive Vss.

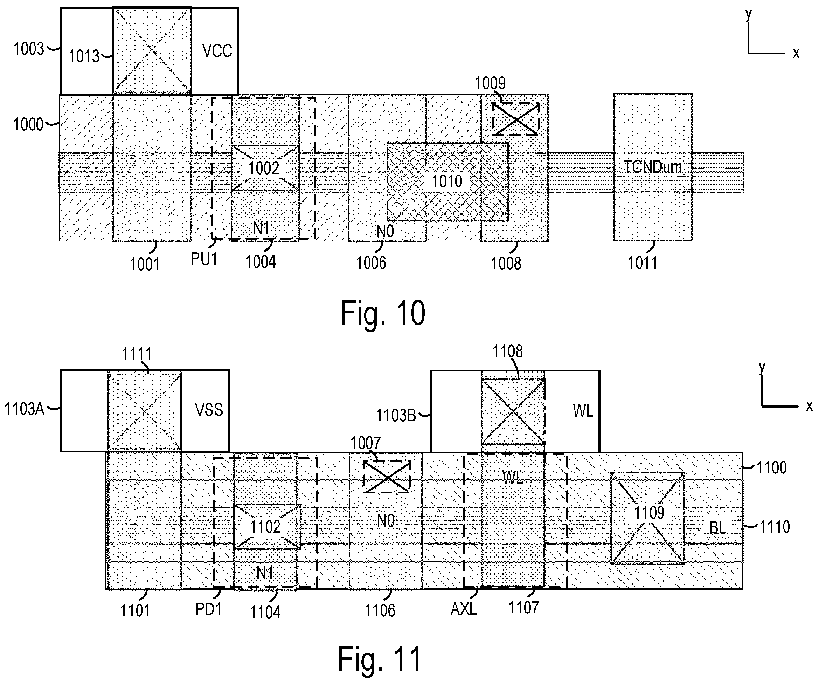

FIG. 9 depicts a layout of the top-middle pMOS layer 340 of FIG. 3, in an example four-level implementation of the SRAM cell of FIG. 4A, according to various embodiments. The pMOS region 900 includes the transistor PU2. A conductive path 901 is a dummy path which is not used. A conductive path 911 is coupled by a via 1002 down to the conductive path 1004 of the bottom-middle pMOS layer of FIG. 10. The conductive path 1004 in turn is coupled by a via 1102 down to the conductive path 1104 of the bottom nMOS layer of FIG. 11.

The conductive path 911 is also coupled laterally by a conductive path 903 (a GCN) to a conductive path 904 representing N1, which overlies a source/drain region of PU2. The conductive path 904 is coupled to the top nMOS layer by the via 907, as discussed. A conductive path 906 forms a control gate of PU2 and is coupled by a via 907 to the top nMOS layer, as discussed. A conductive path 908 overlies another source/drain region of PU2 and is coupled by a via 909 down to an IM0 portion 910 to receive Vcc.

FIG. 10 depicts a layout of the bottom-middle pMOS layer 330 of FIG. 3, in an example four-level implementation of the SRAM cell of FIG. 4A, according to various embodiments. The pMOS region 1000 includes the transistor PU1. A conductive path 1001 is coupled by a via 1013 up to an IM0 portion 1003 to receive Vcc. A conductive path 1004 forms a control gate of PU1 and is coupled down by a via 1002 to the conductive path 1104 (N1) which forms the control gate of PD1 in the bottom nMOS layer (FIG. 11).

A conductive path 1006 (N0) overlays a source/drain region of PU1 and is coupled laterally by a conductive path 1010 (GCN) to a conductive path 1008. The conductive path 1006 is also coupled down by a via 1007 to the conductive path 1106 which overlays a source/drain of PD1 and AXL. The conductive path 1008 is coupled up by a via 1009 to the conductive path 906 which forms the control gate of PD2 (FIG. 9). A conductive path 1011 is a dummy TCN which is not used.

FIG. 11 depicts a layout of the bottom nMOS layer 320 of FIG. 3, in an example four-level implementation of the SRAM cell of FIG. 4A, consistent with the nMOS layer 320 in FIG. 3, according to various embodiments. The nMOS region 1100 includes transistors PD1 and AXL. A conductive path 1101 is coupled by a via 1111 down to a BM0 portion 1103A to receive Vss. A conductive path 1104 forms a control gate of PD1 and is coupled up by the via 1002 to the conductive path 1004 of FIG 10, as discussed. A conductive path 1106 (node N0) which overlies a source/drain region of PD1 and AXL is coupled up by the via 1007 to the conductive path 1006 (FIG. 10), as discussed. A conductive path 1107 forms a control gate of AXL and is coupled down by a via 1108 to a BM0 portion 1103B to receive the WL voltage. A via 1109 which is coupled down to BL (bit line 1110) in BM0 overlies a source/drain region of AXL.

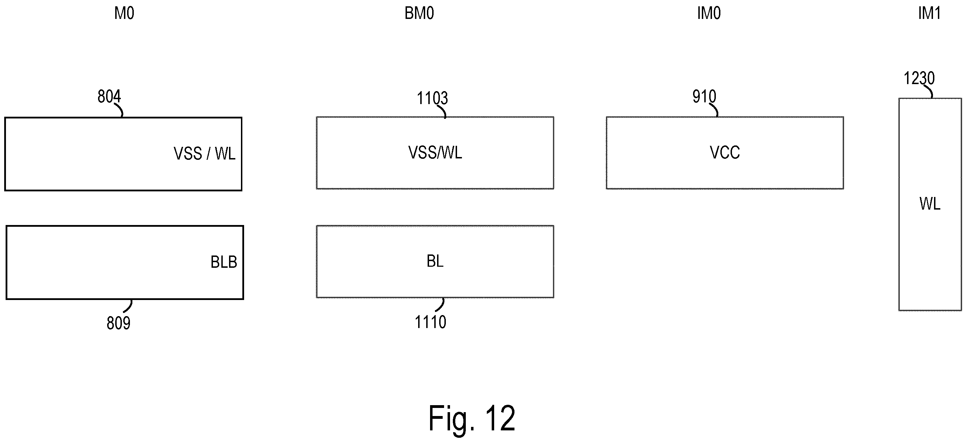

FIG. 12 depicts a layout of front, intermediate and back side metal layers in an example implementation of the SRAM cell of FIG. 4A, consistent with FIGs. 8-11, according to various embodiments. The M0 layer includes an M0 portion 804 for Vss and WL, and an M0 portion 809 for BLB. The BM0 layer includes a BM0 portion 1103 for Vss and WL, and a BM0 portion 1110 for BL. The IM0 layer includes an IM0 portion 910 for Vcc. The IM0 portion 1003 in FIG. 10 is also connected to the IM0 layer for the Vcc. The IM1 layer includes an IM1 portion 1230 which can extend perpendicular to the IM0 portion. See also FIG. 14.

The bit lines are thus on opposite sides of the CFET device. Specifically, BLB is on the front side and BL is on the back side, in this example implementation. Other configurations are possible.

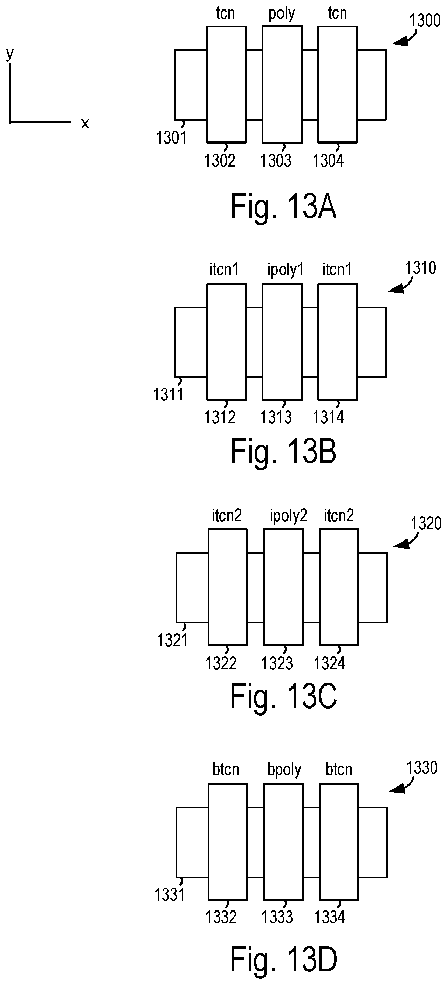

FIG. 13A depicts a layout of control gate and sources/drains of conductive paths of the top nMOS layer 350 of FIG. 3, in an example four-level implementation of the SRAM cell of FIG. 4A, according to various embodiments. The layout is in the x-y plane. The layout 1300 includes an active area 1301 and conductive paths tcn 1302, poly 1303 and tcn 1304, which extend over the active area. See also FIG. 14 for example naming conventions for lateral and vertical conductive paths as used herein.

FIG. 13B depicts a layout of control gate and source/drain paths of the top-middle pMOS layer 340 of FIG. 3, in an example four-level implementation of the SRAM cell of FIG. 4A, according to various embodiments. The layout 1310 includes an active area 1311 and conductive paths itcn1 1312, ipoly1 1313 and itcn1 1314 which extend over the active area.

FIG. 13C depicts a layout of control gate and source/drain paths of the bottom-middle pMOS layer 330 of FIG. 3, in an example four-level implementation of the SRAM cell of FIG. 4A, according to various embodiments. The layout 1320 includes an active area 1321 and conductive paths itcn2 1322, ipoly2 1323 and itcn2 1324 which extend over the active area.

FIG. 13D depicts a layout of control gate and source/drain paths of the bottom nMOS layer 320 of FIG. 3, in an example four-level implementation of the SRAM cell of FIG. 4A, according to various embodiments. The layout 1330 includes an active area 1331 and conductive paths btcn 1332, bpoly 1333 and btcn 1334, which extend over the active area.

FIG. 14 depicts an example perspective view of conductive paths in an example four-level implementation of the SRAM cell of FIG. 4A, according to various embodiments. The conductive paths can include vias which extend in the z direction, and lateral paths which extend in the x or y direction. Regions 1450, 1440, 1430 and 1420 are associated with the conductive paths in the top, top-middle, bottom-middle and bottom layers, respectively of the CFET device.

This example includes first, second and third bottom metal layers BM0, BM1 and BM2, respectively, below the bottom layer (region 1420). BM0 and BM2 extend in the x direction, and BM1 extends in the y direction. First, second and third top metal layers M0, M1 and M2, respectively, are above the top layer (region 1450). M0 and M2 extend in the x direction, and M1 extends in the y direction. First and second intermediate metal layers IM0 and IM1, respectively, are between the second and third layers (regions 1440 and 1430), respectively. IM0 extends in the x direction, and IM1 extends in the y direction.

A via bv1 extends up from BM2 to BM1. A via bv0 extends up from BM1 to BM0. A via bvt extends up from BM0 to a trench contact node btcn, and a via bvg extends up from BM0 to a polysilicon path bpoly in the region 1420.

A via ivt2 extends up from btcn to trench contact node itcn2, and a via ivg2 extends up from bpoly to polysilicon path ipoly2 in the region 1430.

A via vtt extends up from itcn2 to itcn1, and a via vgg extends up from ipoly2 to ipoly1 in the region 1440. The path itcn1 can be coupled down to IM0 by a via ivt1, and the path ipoly1 can be coupled down to IM0 by a via ivg1.

A via ivtt extends up from itcn1 to tcn, and a via ivgg extends up from ipoly1 to poly in the region 1450.

A via vcp also extends up from IM0 to a path tcn.

A via vt extends up from tcn to M0, and a via vg extends up from poly to M0.

A via iv0 extends down from IM0 to IM1.

A via v0 extends up from M0 to M1, and a via v1 extends up from M1 to M2.

M0 can also extend down in the via vgx to ipoly1, and in the via vtx to itcn1.

The conductive paths in the CFET devices of FIGs. 5, 6 and 8-11 can be understood further in view of FIG. 14. For example, in FIG. 8, the paths 802 and 806 corresponds to poly, and the vias 803 corresponds to vg and 808 corresponds to vt. The path 805 corresponds to tcn. In FIG. 9, the paths 901, 904 and 908 corresponds to itcn1, the path 906 corresponds to ipoly1, the via 907 corresponds to ivgg, and the via 909 corresponds to ivt1. In FIG. 10, the paths 1001, 1006, and 1011 correspond to itcn2, the path 1004 corresponds to ipoly2, the via 1002 corresponds to ivg2, and the via 1009 corresponds to vtt. In FIG. 11, the paths 1101 and 1106 correspond to btcn, the paths 1104 and 1107 correspond to bpoly, the via 1111 corresponds to bvt, the via 1102 corresponds to ivg2, the via 1007 corresponds to ivt2, and the via 1108 corresponds to bvg.

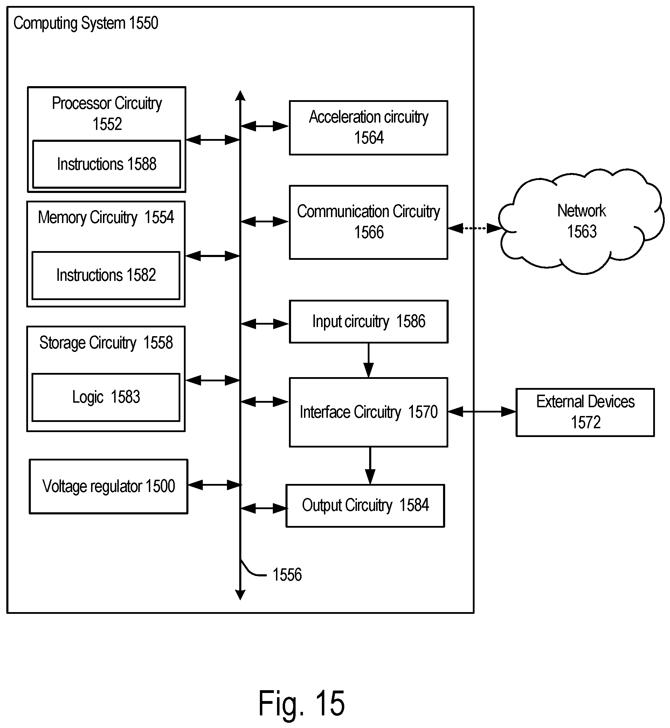

FIG. 15 illustrates an example of components that may be present in a computing system 1550 for implementing the techniques (e.g., operations, processes, methods, and methodologies) described herein.

The computing system 1550 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1550, or as components otherwise incorporated within a chassis of a larger system. The CFET device described herein can be used in any of the components of the computing system 1550.

In an example implementation, the CFET device is provided one or more of the processor circuitry 1552, memory circuitry 1554, storage circuitry 1558, voltage regulator 1500, acceleration circuitry 1564, communication circuitry 1566, input circuitry 1586, interface circuitry 1570, external devices 1572 or output circuitry 1584. In one approach, all or part of the computing system 1550 is provided in a SoP, System in Package (SiP) or a System on Chip (SoC).

The voltage regulator can provide a voltage Vout to one or more of the components of the computing system 1550. The memory circuitry 1554 may store instructions and the processor circuitry 1552 may execute the instructions to perform the functions described herein.

The system 1550 includes processor circuitry in the form of one or more processors 1552. The processor circuitry 1552 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1552 may include one or more hardware accelerators (e.g., same or similar to acceleration circuitry 1564), which may be microprocessors, programmable processing devices (e.g., FPGA, ASIC, etc.), or the like. The one or more accelerators may include, for example, computer vision and/or deep learning accelerators. In some implementations, the processor circuitry 1552 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1552 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1552 may be coupled with or may include memory/storage and may be configured to execute instructions stored in the memory/storage to enable various applications or operating systems to run on the platform 1550. The processors (or cores) 1552 is configured to operate application software to provide a specific service to a user of the platform 1550. In some embodiments, the processor(s) 1552 may be a special-purpose processor(s)/controller(s) configured (or configurable) to operate according to the various embodiments herein.

As examples, the processor(s) 1552 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1552 may be a part of a system on a chip (SoC), System-in-Package (SiP), a multi-chip package (MCP), and/or the like, in which the processor(s) 1552 and other components are formed into a single integrated circuit, or a single package, such as the Edison^{™} or Galileo^{™} SoC boards from Intel^{®} Corporation. Other examples of the processor(s) 1552 are mentioned elsewhere in the present disclosure.

The system 1550 may include or be coupled to acceleration circuitry 1564, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1564 may comprise logic blocks or logic fabric and other interconnected resources that may be programmed (configured) to perform various functions, such as the procedures, methods, functions, etc. of the various embodiments discussed herein. In such implementations, the acceleration circuitry 1564 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1552 and/or acceleration circuitry 1564 may include hardware elements specifically tailored for machine learning and/or artificial intelligence (AI) functionality. In these implementations, the processor circuitry 1552 and/or acceleration circuitry 1564 may be, or may include, an AI engine chip that can run many different kinds of AI instruction sets once loaded with the appropriate weightings and training code. Additionally or alternatively, the processor circuitry 1552 and/or acceleration circuitry 1564 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1552 and/or acceleration circuitry 1564 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 1550 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1550 also includes system memory 1554. Any number of memory devices may be used to provide for a given amount of system memory. As examples, the memory 1554 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1554 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1554 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1558 provides persistent storage of information such as data, applications, operating systems and so forth. In an example, the storage 1558 may be implemented via a solid-state disk drive (SSDD) and/or high-speed electrically erasable memory (commonly referred to as "flash memory"). Other devices that may be used for the storage 1558 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1554 and/or storage circuitry 1558 may also incorporate three-dimensional (3D) cross-point (XPOINT) memories from Intel^{®} and Micron^{®}.

The memory circuitry 1554 and/or storage circuitry 1558 is/are configured to store computational logic 1583 in the form of software, firmware, microcode, or hardware-level instructions to implement the techniques described herein. The computational logic 1583 may be employed to store working copies and/or permanent copies of programming instructions, or data to create the programming instructions, for the operation of various components of system 1550 (e.g., drivers, libraries, application programming interfaces (APIs), etc.), an operating system of system 1550, one or more applications, and/or for carrying out the embodiments discussed herein. The computational logic 1583 may be stored or loaded into memory circuitry 1554 as instructions 1582, or data to create the instructions 1582, which are then accessed for execution by the processor circuitry 1552 to carry out the functions described herein. The processor circuitry 1552 and/or the acceleration circuitry 1564 accesses the memory circuitry 1554 and/or the storage circuitry 1558 over the interconnect (IX) 1556. The instructions 1582 direct the processor circuitry 1552 to perform a specific sequence or flow of actions, for example, as described with respect to flowchart(s) and block diagram(s) of operations and functionality depicted previously. The various elements may be implemented by assembler instructions supported by processor circuitry 1552 or high-level languages that may be compiled into instructions 1588, or data to create the instructions 1588, to be executed by the processor circuitry 1552. The permanent copy of the programming instructions may be placed into persistent storage devices of storage circuitry 1558 in the factory or in the field through, for example, a distribution medium (not shown), through a communication interface (e.g., from a distribution server (not shown)), over-the-air (OTA), or any combination thereof.

The IX 1556 couples the processor 1552 to communication circuitry 1566 for communications with other devices, such as a remote server (not shown) and the like. The communication circuitry 1566 is a hardware element, or collection of hardware elements, used to communicate over one or more networks 1563 and/or with other devices. In one example, communication circuitry 1566 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1566 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1556 also couples the processor 1552 to interface circuitry 1570 that is used to connect system 1550 with one or more external devices 1572. The external devices 1572 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1550, which are referred to as input circuitry 1586 and output circuitry 1584. The input circuitry 1586 and output circuitry 1584 include one or more user interfaces designed to enable user interaction with the platform 1550 and/or peripheral component interfaces designed to enable peripheral component interaction with the platform 1550. Input circuitry 1586 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1584 may be included to show information or otherwise convey information, such as sensor readings, actuator position(s), or other like information. Data and/or graphics may be displayed on one or more user interface components of the output circuitry 1584. Output circuitry 1584 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1550. The output circuitry 1584 may also include speakers and/or other audio emitting devices, printer(s), and/or the like. Additionally or alternatively, sensor(s) may be used as the input circuitry 1584 (e.g., an image capture device, motion capture device, or the like) and one or more actuators may be used as the output device circuitry 1584 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1550 may communicate over the IX 1556. The IX 1556 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1556 may be a proprietary bus, for example, used in a SoC based system.

The number, capability, and/or capacity of the elements of system 1550 may vary, depending on whether computing system 1550 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1550 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a substrate; a plurality of transistor layers stacked one above the other on the substrate, wherein the plurality of transistor layers comprise a bottom n-type transistor layer, a bottom-middle p-type transistor layer on the bottom n-type transistor layer, a top-middle p-type transistor layer on the bottom-middle p-type transistor layer, and a top n-type transistor layer on the top-middle p-type transistor layer, and the plurality of transistor layers are part of a Static Random-Access Memory (SRAM) cell; and interconnects to couple to the transistors in the plurality of layers.

Example 2 includes the apparatus of Example 1, wherein the interconnects include one or more bottom metal layers below the substrate, one or more top metal layers above the top n-type transistor layer, and one or more intermediate metal layers between the bottom-middle and top-middle p-type transistor layers.

Example 3 includes the apparatus of Example 2, wherein: a primary bit line for the SRAM cell is in the one or more bottom metal layers; and a complementary bit line for the SRAM cell is in the one or more top metal layers.

Example 4 includes the apparatus of any one of Examples 1-3, further comprising, as part of the SRAM cell: two n-channel metal-oxide-semiconductor field-effect transistors (nMOSFET) in the bottom n-type transistor layer; a p-type MOSFET in the bottom-middle p-type transistor layer; a p-type MOSFET in the top-middle p-type transistor layer; and two n-type MOSFETs in the top n-type transistor layer.

Example 5 includes the apparatus of Example 4, wherein the interconnects comprise a via (905) to couple a source/drain region of the two n-type MOSFETs in the top n-type transistor layer to a source/drain region of the p-type MOSFET in the top-middle p-type transistor layer.

Example 6 includes the apparatus of Example 4 or 5, wherein the interconnects comprise a via (907) to couple a control gate of one of the two n-type MOSFETs in the top n-type transistor layer to a control gate of the p-type MOSFET in the top-middle p-type transistor layer.

Example 7 includes the apparatus of any one of Examples 4-6, wherein the interconnects are to couple a control gate of the p-type MOSFET in the bottom-middle p-type transistor layer to a source/drain region of the p-type MOSFET in the top-middle p-type transistor layer.

Example 8 includes the apparatus of any one of Examples 4-7, wherein the interconnects comprise a via (1002) to couple a control gate of the p-type MOSFET in the bottom-middle p-type transistor layer to a control gate of one of the n-type MOSFETs in the bottom n-type transistor layer.

Example 9 includes the apparatus of any one of Examples 4-8, wherein: the SRAM cell comprises a first inverter and a second inverter; the first inverter comprises one of the n-type MOSFETs in the bottom n-type transistor layer and the p-type MOSFET in the bottom-middle p-type transistor layer; and the second inverter comprises one of the n-type MOSFETs in the top n-type transistor layer and the p-type MOSFET in the top-middle p-type transistor layer.

Example 10 includes the apparatus of any one of Examples 4-9, wherein: the SRAM cell comprises a first bit line access transistor and a second bit line access transistor; the first access transistor is one of the n-type MOSFETs in the bottom n-type layer; and the second access transistor is one of the n-type MOSFETs in the top n-type transistor layer.

Example 11 includes the apparatus of any one of Examples 1-10, wherein the SRAM cell is a six-transistor cell.

Example 12 includes the apparatus of any one of Examples 1-11, wherein the substrate, the plurality of transistor layers and the interconnects are provided in at least one of a processor, memory, storage, voltage regulator, acceleration circuitry, communication circuitry, input circuitry, interface circuitry, or output circuitry of a computing device.

Example 13 includes a Static Random-Access Memory (SRAM) cell, comprising: a first inverter comprising an n-type transistor and a p-type transistor in series; a second inverter comprising an n-type transistor and a p-type transistor in series; a first n-type access transistor connected to an output of the first inverter; and a second n-type access transistor connected to an output of the second inverter.

Example 14 includes the SRAM cell of Example 13, wherein: the n-type transistor of the first inverter and the first n-type access transistor are in a first layer of a stack; the p-type transistor of the first inverter is in a second layer of the stack, above the first layer; the p-type transistor of the second inverter is in a third layer of the stack, above the second layer; and the n-type transistor of the second inverter and the second access transistor are in a fourth layer of the stack, above the third layer.

Example 15 includes the SRAM cell of Example 14, wherein interconnects for the SRAM cell comprise: one or more bottom metal layers below the first layer of the stack; one or more top metal layers above the fourth layer of the stack; and one or more intermediate metal layers between the second and third layers of the stack.

Example 16 includes the SRAM cell of Example 14 or 15, wherein interconnects for the SRAM cell comprise: one or more vias to couple the first layer to the second layer; one or more vias to couple the second layer to the third layer; and one or more vias to couple the third layer to the fourth layer.

Example 17 includes the SRAM cell of any one of Examples 13-16, wherein the SRAM cell is a complementary-field effect transistor (CFET) device.

Example 18 includes a system, comprising: a processor circuitry; and a memory circuitry coupled to the processor circuitry, wherein the memory circuitry comprises a memory cell having transistors arranged in a complementary-field effect transistor (CFET) device having at least four levels.

Example 19 includes the system of Example 18, wherein the memory cell is a six-transistor cell Static Random-Access Memory (SRAM) cell.

Example 20 includes the system of Example 18 or 19, wherein the four-level CFET device comprises a plurality of layers in a stack, and the plurality of layers comprises: a bottom n-type transistor layer; a bottom-middle p-type transistor layer above the bottom n-type transistor layer; a top-middle p-type transistor layer above the bottom-middle p-type transistor layer; and a top n-type transistor layer above the top-middle p-type transistor layer.

Example 21 includes a method, comprising: receiving signals on a primary bit line, a complementary bit line and a word line of a Static Random-Access Memory (SRAM) cell, wherein the SRAM cell comprises: two n-channel metal-oxide-semiconductor field-effect transistors (nMOSFET) in a bottom n-type transistor layer of a stack; a p-type MOSFET in a bottom-middle p-type transistor layer of the stack; a p-type MOSFET in the top-middle p-type transistor layer of the stack; and two n-type MOSFETs in the top n-type transistor layer of the stack.

Example 22 includes the method of Example 21, wherein: the SRAM cell comprises a first bit line access transistor and a second bit line access transistor; the first access transistor is one of the n-type MOSFETs in the bottom n-type layer; and the second access transistor is one of the n-type MOSFETs in the top n-type transistor layer.

Example 23 includes an apparatus, comprising means to perform the method of Example 21 or 22.

Example 24 includes a machine-readable storage including machine-readable instructions which, when executed, cause a computer to implement the method of Example 21 or 22.

Example 25 includes a computer program comprising instructions which, when executed by a computer, cause the computer to carry out the method of Example 21 or 22.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a substrate;
a plurality of transistor layers stacked one above the other on the substrate, wherein the plurality of transistor layers comprise a bottom n-type transistor layer, a bottom-middle p-type transistor layer on the bottom n-type transistor layer, a top-middle p-type transistor layer on the bottom-middle p-type transistor layer, and a top n-type transistor layer on the top-middle p-type transistor layer, and the plurality of transistor layers are part of a Static Random-Access Memory (SRAM) cell; and
interconnects to couple to the transistors in the plurality of layers.

2. The apparatus of claim 1, wherein the interconnects include one or more bottom metal layers below the substrate, one or more top metal layers above the top n-type transistor layer, and one or more intermediate metal layers between the bottom-middle and top-middle p-type transistor layers.

3. The apparatus of claim 2, wherein:
a primary bit line for the SRAM cell is in the one or more bottom metal layers; and
a complementary bit line for the SRAM cell is in the one or more top metal layers.

4. The apparatus of any one of claims 1-3, further comprising, as part of the SRAM cell:
two n-channel metal-oxide-semiconductor field-effect transistors (nMOSFET) in the bottom n-type transistor layer;
a p-type MOSFET in the bottom-middle p-type transistor layer;
a p-type MOSFET in the top-middle p-type transistor layer; and
two n-type MOSFETs in the top n-type transistor layer.

5. The apparatus of claim 4, wherein the interconnects comprise a via to couple a source/drain region of the two n-type MOSFETs in the top n-type transistor layer to a source/drain region of the p-type MOSFET in the top-middle p-type transistor layer.

6. The apparatus of claim 4 or 5, wherein the interconnects comprise a via to couple a control gate of one of the two n-type MOSFETs in the top n-type transistor layer to a control gate of the p-type MOSFET in the top-middle p-type transistor layer.

7. The apparatus of any one of claims 4-6, wherein the interconnects are to couple a control gate of the p-type MOSFET in the bottom-middle p-type transistor layer to a source/drain region of the p-type MOSFET in the top-middle p-type transistor layer.

8. The apparatus of any one of claims 4-7, wherein the interconnects comprise a via (1002) to couple a control gate of the p-type MOSFET in the bottom-middle p-type transistor layer to a control gate of one of the n-type MOSFETs in the bottom n-type transistor layer.

9. The apparatus of any one of claims 4-8, wherein:
the SRAM cell comprises a first inverter and a second inverter;
the first inverter comprises one of the n-type MOSFETs in the bottom n-type transistor layer and the p-type MOSFET in the bottom-middle p-type transistor layer; and
the second inverter comprises one of the n-type MOSFETs in the top n-type transistor layer and the p-type MOSFET in the top-middle p-type transistor layer.

10. The apparatus of claim 9, wherein the SRAM cell comprises a first bit line access transistor connected to an output of the first inverter and a second bit line access transistor connected to an output of the second inverter.

11. The apparatus of claim 10, wherein the first and second bit line access transistors are n-type transistors.

12. The apparatus of claim 11, wherein:
an n-type transistor of the first inverter and the first bit line access transistor are in a first layer of a stack;
a p-type transistor of the first inverter is in a second layer of the stack, above the first layer;
a p-type transistor of the second inverter is in a third layer of the stack, above the second layer; and
a n-type transistor of the second inverter and the second access transistor are in a fourth layer of the stack, above the third layer.

13. The apparatus of any one of claims 4-12, wherein:
the SRAM cell comprises a first bit line access transistor and a second bit line access transistor;
the first access transistor is one of the n-type MOSFETs in the bottom n-type layer; and
the second access transistor is one of the n-type MOSFETs in the top n-type transistor layer.

14. The apparatus of any one of claims 1-13, wherein the SRAM cell is a six-transistor cell.

15. The apparatus of any one of claims 1-14, wherein the substrate, the plurality of transistor layers and the interconnects are provided in at least one of a processor, memory, storage, voltage regulator, acceleration circuitry, communication circuitry, input circuitry, interface circuitry, or output circuitry of a computing device.
